# EUROPEAN PATENT SPECIFICATION

(11) **EP 2 930 821 B1**
(45) Date of publication and mention of the grant of the patent: **11.01.2017**
(21) Application number: 15162300.6
(22) Date of filing: 02.04.2015
(51) Int. Cl.: H02J 7/34, H02J 7/00

(54) **SYSTEMS AND METHODS FOR ADAPTIVE FAST-CHARGING FOR MOBILE DEVICES AND DEVICES HAVING SPORADIC POWER-SOURCE CONNECTION**
SYSTEME UND VERFAHREN ZUR ADAPTIVEN SCHNELLLADUNG VON MOBILGERÄTEN UND GERÄTEN MIT SPORADISCHER VERBINDUNG ZU EINER ENERGIEQUELLE
SYSTÈMES ET MÉTHODES POUR LA RECHARGE RAPIDE ADAPTIVE POUR DES DISPOSITIFS PORTABLES ET DES DISPOSITIFS AVEC UNE CONNEXION SPORADIQUE AVEC UNE SOURCE D'ÉNERGIE

(30) Priority: 08.04.2014 US 201461976551 P
(43) Date of publication of application: 14.10.2015
(73) Proprietor: StoreDot Ltd., Herzeliya 4672503 (IL)
(72) Inventor: Aronov, Daniel, 4201744 Netanya (IL); Krasovitsky, Leonid, 7523905 Rishon leZion (IL)
(74) Representative: Pearl Cohen Zedek Latzer Baratz UK LLP

(56) References cited:
- EP-A1- 2 590 050
- EP-A2- 1 453 176
- CN-A- 103 701 164
- US-A1- 2005 052 161
- US-A1- 2010 066 309
- US-A1- 2011 084 845
- US-A1- 2012 145 485
- US-A1- 2013 088 082
- US-A1- 2014 083 443

## Description

### CROSS REFERENCE TO RELATED APPLICATIONS

This patent application claims priority under 35 U.S.C. §119(e) to U.S. Provisional Patent Application No. 61/976,551 filed April 8, 2014.

### FIELD AND BACKGROUND OF THE INVENTION

The present invention relates to systems and methods for adaptive fast-charging for mobile devices and devices having sporadic power-source connection.

Modem electronic appliances are becoming ubiquitous for personal as well as business use. It cannot be overstated that with the evolution of such devices, mobility has emerged as a key driver in feature enhancement for technological innovation. While the rapid advancement of low power-consumption processors and flash-memory devices have enabled such mobility to reach new levels of real-world productivity, further development is significantly hampered by the rather slow progress made in battery technology. The proliferation of smart phones, tablets, laptops, ultrabooks, and the like (acquiring smaller and smaller form factors) has made this issue even more abundantly apparent as consumers are eager to have longer and longer device usage times between recharge cycles, without adding heft to the weight and footprint of such devices.

Furthermore, electrical and electronic components that don't fall under the mobile rubric are also in need of extended usage solutions. Such components include devices having sporadic power-source connection (e.g., backup emergency sentinels, remotely-stationed telecommunication repeaters, electric vehicle console communicators, as well as off-shore communication, control, and positioning devices).

The demands of such applications vary widely, for example, in voltage or power level, but all are preferably served by lightweight, power-storage devices which can rapidly and consistently provide high energy density over long time spans, and can be quickly recharged to operational energy levels. To date, such extensive mobile energy needs are being met in part by one of two available types of power-storage devices: rechargeable batteries (e.g., lithium-ion intercalation systems) or supercapacitors (e.g., Faradic pseudo-capacitive type, non-Faradic double-layer reaction types, or hybrid types).

To meet the growing demand in portable electronic devices and devices having sporadic power-source connection, energy storage devices with high specific energy, high power density, long cycle life, low cost, and a high margin of safety must be employed.

Currently, the dominant energy storage device remains the battery, particularly the lithium-ion battery. Lithium-ion batteries power nearly every portable electronic device, as well as almost every electric car, including the Tesla Model S and the Chevy Volt. Batteries store energy electrochemically, in which chemical reactions release electrical carriers that can be extracted into an electrical circuit. During discharge, the energy-containing lithium ions travel from a high-energy anode material through a separator to a low-energy cathode material. The movement of the lithium ions releases energy, which is extracted into an external circuit.

During battery charging, energy is used to move the lithium ions back to the high-energy anode compound. The charge and discharge process in batteries is a slow process, and can degrade the chemical compounds inside the battery over time. A key bottleneck in achieving enhanced performance is the limited fast-charging ability of any standard battery. Rapid charging causes accelerated degradation of the battery constituents, as well as a potential fire hazard due to a localized, over-potential build-up and increased heat generation.

For example, Li-ion batteries have the highest energy density of rechargeable batteries available, but typically suffer from low power by virtue of reversible Coulombic reactions occurring at both electrodes, involving charge transfer and ion diffusion in bulk electrode materials. Since both diffusion and charge transfer are slow processes, power delivery as well as the recharge time of Li-ion batteries is kinetically limited. As a result, batteries have a low power density, and lose their ability to retain energy throughout their lifetime due to material degradation.

On the other extreme, electrochemical double-layer capacitors (EDLCs) or ultracapacitors are, together with pseudocapacitors, part of a new type of electrochemical capacitors called supercapacitors (hereinafter referred to as SCs), which store energy through accumulation of ions on an electrode surface, have limited energy storage capacity, but very high power density. In such SCs, energy is stored electrostatically on the surface of the material, and does not involve a chemical reaction. As a result, SCs can be charged quickly, leading to a very high power density, and do not lose their storage capabilities over time. SCs can last for millions of charge/discharge cycles without losing energy storage capability. The main shortcoming of SCs is their low energy density, meaning that the amount of energy SCs can store per unit weight is very small, particularly when compared to batteries.

The most intuitive approach to combine high energy and high power density within a single device is to combine different types of energy storage sources. So far, such hybrid power-source devices involving SCs and batteries have mainly been explored in view of parallel connection (i.e., an SC is being used as a power supply, while the battery is used as an energy source, which supplies energy both to the load and to the SC, which in turn, should be charged at all times). The contribution of components to the total stored charge is not optimal, due to the minimal use of the SC, and the higher degradation of the battery due to the additional charging of the SC.

In the prior art, Kan et al. published findings (Journal of Power Sources, 162(2), 971-974, 2006) analyzing combinations of rechargeable batteries and capacitors in storage media of photovoltaic-powered products. In such applications, the focus of the study was to reduce power cycling of the batteries by utilizing a well-defined recharge duty cycle.

Buiel et al. published findings at the Capacitor and Resistor Technology *Symposium (CARTS International 2013)* on development of ultrathin ultracapacitors for enhanced lithium batteries in portable electronic applications. The focus of the study was to extend the usable energy stored on lithium batteries by compensating for voltage droop during GSM radio pulses by employing an SC to discharge to the lithium battery when the low-voltage cutoff of the main battery is reached. Similarly, this was also partly the subject of International Patent Publication No. WO/2006/112698 for a rechargeable power supply.

EP1453176A2 discloses a mobile phone charger provided with a power input portion, a switching power source portion to which electric power is supplied by the power input portion, a control portion having a micro-computer logic circuit and supplied with electric energy by the switching power source portion, a capacitor portion having plural electric double-layer capacitors to accumulate the electric energy supplied by the control portion, a feedback circuit transmitting charging state of the electric double-layer capacitors to the control portion, and an output portion to supply the electric energy accumulated in the electric double-layer capacitors to a battery of a mobile phone with constant voltage.

US2010066309A1 discloses a method for pulsed charging of a battery in an autonomous system comprising a supercapacitance.

EP2590050 A1 discloses a mobile phone with both supercapacitor and battery in which the two power sources are used in parallel. The aim as stated in paragraph [0024] is for the unique energy storage and power supply capabilities of each energy storage device to be used to maximize overall battery life performance. The document briefly mentions the possibility of transferring energy between sources but does not specifically mention charging a battery from a supercapacitor.

CN103701164 A discloses a power supply for a handset in comprising a conventional cell which is charged from a supercapacitor after a conventional charger is removed. Here the superconductor and the battery are directly (parallel) connected. The document does not disclose a device having a control circuit which operates such that upon detecting that the supercapacitor is partially charged and the battery is not fully charged, the battery is charged from the supercapacitor by discharging the supercapacitor.

US2014/083443 A1 discloses an electronic cigarette in which a farad capacitor is used instead of traditional batteries to supply electrical power, in order to achieve safe and reliable charging/ discharging, rapid charging, and more charging and discharging times. It is suggested in paragraph [0007] that a rechargeable battery may be built into the electronic cigarette casing and connected to a charging control module for charging the electronic cigarettes or the first farad capacitor. This operates in the opposite way to the present invention in that the battery charges the capacitor rather than vice versa.

It would be desirable to have systems and methods for adaptive fast-charging for mobile devices and devices having sporadic power-source connection. Such systems and methods would, inter alia, overcome the various limitations mentioned above.

### SUMMARY

It is the purpose of the present invention to provide systems and methods for adaptive fast-charging for mobile devices and devices having sporadic power-source connection.

According to one aspect of the invention there is provided a method of adaptive fast-charging of a mobile device or other device having sporadic power-source connection, the device comprising one or more supercapacitors and one or more rechargeable batteries and being configured for charging at least the one or more supercapacitors from an external charger, the method comprising, when the device is not connected to an external charger: determining whether a supercapacitor of said device is at least partially charged; upon detecting said supercapacitor is at least partially charged, determining whether a battery of said device is fully charged; and upon detecting said battery is not fully charged, charging said battery by discharging said supercapacitor.

It is noted that the term "exemplary" is used herein to refer to examples of embodiments and/or implementations, and is not meant to necessarily convey a more-desirable use-case. Similarly, the terms "preferred" and "preferably" are used herein to refer to an example out of an assortment of contemplated embodiments and/or implementations, and is not meant to necessarily convey a more-desirable use-case. Therefore, it is understood from the above that "exemplary" and "preferred" may be applied herein to multiple embodiments and/or implementations.

Preferred embodiments of the present invention enable adaptive fast-charging of mobile devices and devices having sporadic power-source connection by incorporating high-energy SCs in combination with rechargeable batteries, allowing for higher system power, while preserving the energy density of the battery in a device-compatible form factor.

Features of such adaptive fast-charging systems and methods include, inter alia the following aspects.
➢ Fast charging (due to SC properties)
➢ Adaptive charging intervals (via control of battery charging characteristics)
➢ Standard working time
➢ High energy density (due to intrinsic battery properties)
➢ High power density (due to intrinsic SC properties)
➢ Battery lifetime improvement (via control of battery charging characteristics)
➢ High current input allowed
➢ Adaptive battery charging by controlling the current
➢ Can't be overcharged (SC can't be overcharged, and battery charging is controlled)
➢ Can't be overheated (SC can't be overheated, and battery charging is controlled)
➢ Low self-discharge (energy is accumulated in battery, with low intrinsic discharge properties)

Preferably, the step of charging is adaptively regulated to perform at least one task selected from the group consisting of: preserving a lifetime of the battery by controlling a current to the battery, and discharging the supercapacitor in order to charge the battery.

Most preferably, the discharging enables the supercapacitor to be subsequently recharged.

Preferably, the method further includes: prior to determining whether a supercapacitor of said device is at least partially charged, initially determining whether an external charger is connected to the device; and upon detecting the external charger is connected to the device, charging the supercapacitor and/or the battery from the external charger.

Most preferably, the method further includes: upon detecting the external charger is not connected to the device, supplying energy to the device from the supercapacitor and/or the battery.

According to the present invention, there is also provided an electrical or electronic devicecomprising one or more supercapacitors and one or more rechargeable batteries, the device being configured for charging at least the one or more supercapacitors from an external charger; the device comprising: a supercapacitor charging controller configured for determining whether a supercapacitor of said device is at least partially charged; and a battery charging controller configured for determining whether a battery of said device is charged; wherein said battery charging controller is configured for, when the device is not connected to an external charger, upon detecting said supercapacitor of said is at least partially charged and upon detecting said battery is not fully charged charging, by discharging, said battery from said supercapacitor.

Preferably, the firstly charging is adaptively regulated to perform at least one task selected from the group consisting of: preserving a lifetime of the battery by controlling a current to the battery, and discharging the supercapacitor in order to charge the battery.

Most preferably, the discharging enables the supercapacitor to be subsequently recharged.

Preferably, the supercapacitor charging controller is further configured for: prior to the determining whether a supercapacitor of a device is at least partially charged, initially determining whether an external charger is connected to the device; and upon detecting the external charger is connected to the device, charging the supercapacitor and/or the battery from the external charger.

Most preferably, the supercapacitor charging controller is further configured for: upon detecting the external charger is not connected to the device, supplying energy to the device from the supercapacitor and/or the battery.

According to the present invention, there is also provided a non-transitory computer-readable medium, having embodied thereon computer-readable code, the computer-readable code having program code for implementation in and adaptive fast-charging of a mobile device or other device having sporadic power-source connection, the device comprising one or more supercapacitors and one or more rechargeable batteries and being configured for charging at least the one or more supercapacitors from an external charger, wherein the program code when implemented causes the device, when the device is not connected to an external charger,to perform the steps of: determining whether a supercapacitor of said device is at least partially charged; upon detecting said supercapacitor is at least partially charged, determining whether a battery of said device is fully charged; and upon detecting said battery is not fully charged, charging said battery from said supercapacitor.

Preferably, the charging is adaptively regulated to perform at least one task selected from the group consisting of: preserving a lifetime of the battery by controlling a current to the battery, and discharging the supercapacitor in order to charge the battery.

Most preferably, the discharging enables the supercapacitor to be subsequently recharged.

Preferably, the program code when implemented comprising further causes the device to perform the steps of, prior to the determining whether a supercapacitor of said device is at least partially charged, initially determining whether an external charger is connected to the device; and , upon detecting the external charger is connected to the device, charging the supercapacitor and/or the battery from the external charger.

Most preferably, the program code when implemented further causes the device to perform steps of: upon detecting the external charger is not connected to the device, supplying energy to the device from the supercapacitor and/or the battery.

These and further embodiments will be apparent from the detailed description that follows.

### BRIEF DESCRIPTION OF THE DRAWINGS

The present invention is herein described, by way of example only, with reference to the accompanying drawing, wherein:
Figure 1 is a simplified high-level schematic diagram of the device architecture for adaptive fast-charging for mobile devices and devices having sporadic power-source connection, according to preferred embodiments of the present invention;
Figure 2 is a simplified flowchart of the major process steps of an SC controller for adaptive fast-charging for mobile devices and devices having sporadic power-source connection, according to preferred embodiments of the present invention;
Figure 3 is a simplified flowchart of the major process steps of a battery controller for adaptive fast-charging for mobile devices and devices having sporadic power-source connection, according to preferred embodiments of the present invention;
Figure 4 is a simplified flowchart of the major process steps of a device interface controller for adaptive fast-charging for mobile devices and devices having sporadic power-source connection, according to preferred embodiments of the present invention; Figure 5A is a graph of a typical Li-ion battery charge curve, as known in the prior art; Figure 5B is a graph of a typical Li-ion battery discharge curve, as known in the prior art;
Figure 6A is a graph of a typical SC charge curve, as known in the prior art;
Figure 6B is a graph of a typical SC discharge curve, as known in the prior art; Figure 7 is a graph of a FlashBattery charge/discharge simulation in accordance with the simulation parameters of Table 1, according to preferred embodiments of the present invention;
Figure 8 is a graph of a FlashBattery charge/discharge simulation in accordance with the simulation parameters of Table 2, according to preferred embodiments of the present invention;
Figure 9 is a graph of a FlashBattery charge/discharge simulation in accordance with the simulation parameters of Table 3, according to preferred embodiments of the present invention;
Figure 10 is a graph of a FlashBattery charge/discharge simulation in accordance with the simulation parameters of Table 4, according to preferred embodiments of the present invention;
Figure 11 is a graph of a FlashBattery charge/discharge simulation in accordance with the simulation parameters of Table 5, according to preferred embodiments of the present invention.

### DESCRIPTION OF THE PREFERRED EMBODIMENTS

The present invention relates to systems and methods for adaptive fast-charging for mobile devices and devices having sporadic power-source connection. The principles and operation for providing such systems and methods, according to the present invention, may be better understood with reference to the accompanying description and the drawings.

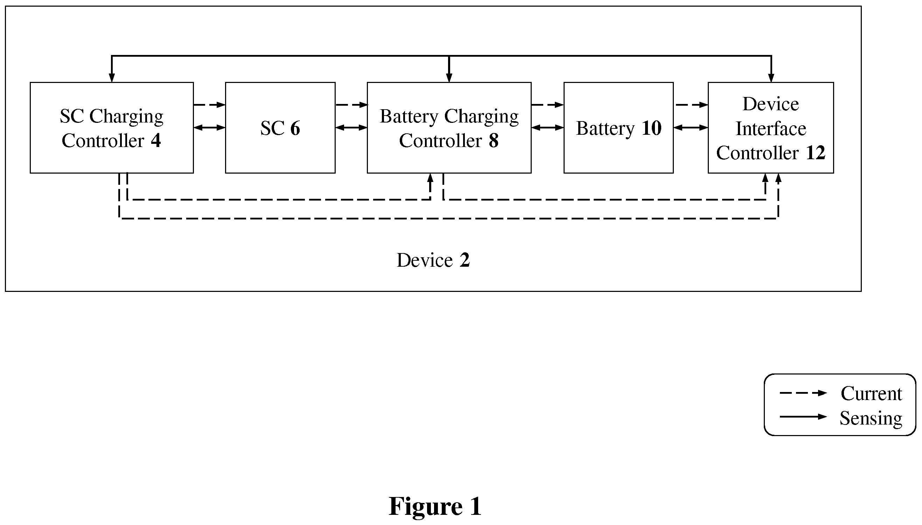

Referring to the drawings, Figure 1 is a simplified high-level schematic diagram of the device architecture for adaptive fast-charging for mobile devices and devices having sporadic power-source connection, according to preferred embodiments of the present invention. A device **2** (i.e., mobile device or a device having sporadic power-source connection) is shown having a SC charging controller **4,** an SC **6,** a battery charging controller **8,** a rechargeable battery **10,** and a device interface controller **12** operationally connected to each other. SC charging controller **4** and battery charging controller **8** each include a charge-sensing element (not shown in Figure 1) for detecting the level of charge on SC **6** and battery **10,** respectively. Charging current flow and charge sensing among the various components are depicted by arrows in Figure 1.

SC charging controller **4** is responsible for charging preferences of SC **6** and/or battery **10.** SC **6** allows for fast charging for operation of device **2,** and is responsible for power and energy accumulation. Battery charging controller **8** is responsible for battery charging preferences and current input from SC **6** and/or from SC charging controller **4.** Battery **10** is responsible for energy and power accumulation. Device interface controller **12** is responsible for energy and power input preferences for device **2** (e.g., laptop, electric car, and cell-phone).

The device architecture of Figure 1 enables an optimal contribution of SC **6** and battery **10** to performance of device **2.** Such device architecture provides a dramatic improvement of battery power capabilities by decoupling power and energy performance, thus increasing the cycle life of the battery. Fast-charging capability is achieved largely by the high power capacity of SC **6,** which can be charged using high current flowing from an external charger (not shown in Figure 1). After charging of SC **6** is complete, the external charger may be disconnected. Then, battery **10** is charged via the charging current from SC **6.** The charge/discharge current flow between SC **6** and battery **10** may be modified according to the indication of SC charging controller **4,** battery charging controller **8,** and device interface controller **12,** thus giving rise to a higher cycle life of device **2.**

SC **6** includes an electrolyte and electrodes. The electrodes may be made from activated carbon powders, carbon nanotubes, carbon nanofibres, carbon aerogels, metal oxides, conductive polymers (such as polyaniline, polypyrrole, polythiophene). In addition, several SCs may be connected in series or/and parallel to form a composite component represented as **SC 6.**

SC charging controller **4** allows high DC current or pulse current inputs, and enables customized charging preferences (e.g., slow and fast discharge options) between SC **6** and battery **10** when an external charger is connected, while monitoring the accumulated charge on each of SC **6** and battery **10.**

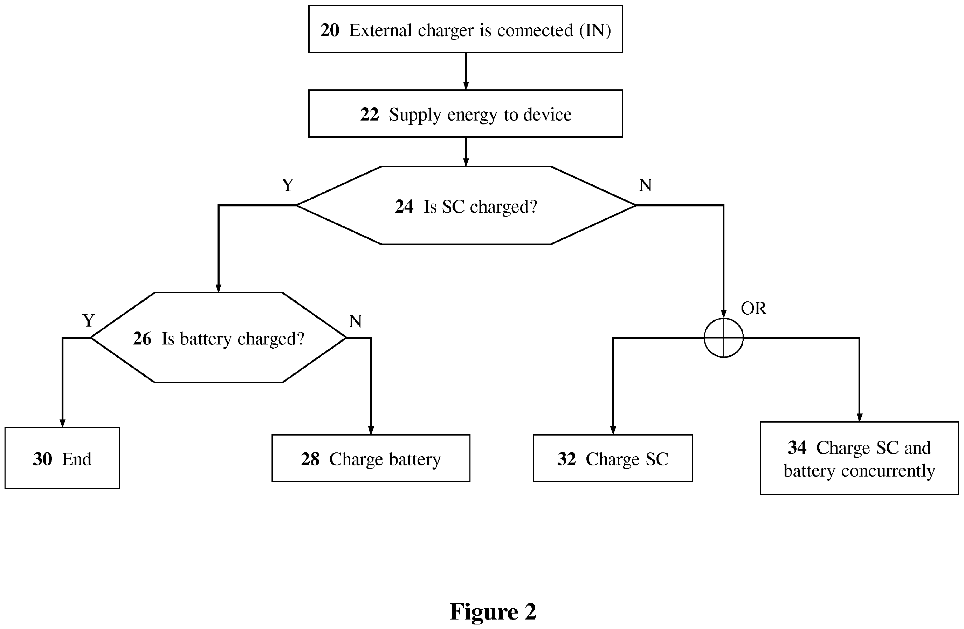

Figure 2 is a simplified flowchart of the major process steps of an SC controller for adaptive fast-charging for mobile devices and devices having sporadic power-source connection, according to preferred embodiments of the present invention. When an external charger is connected to a power source (IN) (Step **20**), energy is supplied from the external charger to device **2** without using the stored energy in SC **6** and/or battery **10** (Step **22**). The energy and power needed for device **2** is drawn from the charger itself, but can be also be supplied from SC **6** and/or battery **10.**

The charge-sensing element of SC charge controller **4** then determines whether SC **6** is fully charged (Step **24**). SC **6** and/or battery **10** receive their charging current from the external charger. The charging current may be continuous current or pulsed. If SC **6** is fully charged, the charge-sensing element of battery charge controller **8** then determines whether battery **10** is fully charged (Step **26**). If battery **10** is not fully charged, energy is supplied from the external charger via charging current to battery **10** (Step **28**). If battery **10** is fully charged, energy is not supplied from the external charger to battery **10,** and the process ends (Step **30).** The external charger may only supply the needed energy and power to device **2.**

If SC **6** is not fully charged in Step **24,** then energy is supplied from the external charger via charging current to SC **6** (Step **32**), or supplied concurrently to both SC **6** and battery **10** (Step **34**)**.**

Battery charging controller **8** allows adjustable current and/or voltage output, and enables customized charging preferences (e.g., slow and fast discharge options) of battery **10** when the external charger is not connected to a power source (OUT), while monitoring the accumulated charge on each of SC **6** and battery **10.** Battery charging controller **8** also serves as an input current/voltage controller via, for example, DC-DC converters (e.g., step-up or step-down transformers).

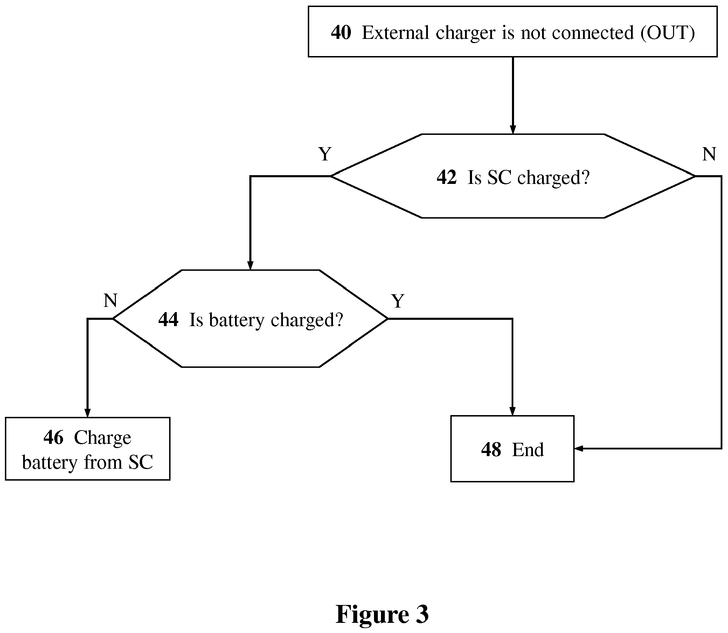

Figure 3 is a simplified flowchart of the major process steps of a battery controller for adaptive fast-charging for mobile devices and devices having sporadic power-source connection, according to preferred embodiments of the present invention. When an external charger is not connected to a power source (OUT) (Step **40**), the charge-sensing element of SC charge controller **4** determines whether SC **6** is fully charged (Step **42**). If SC **6** is even partially charged, the charge-sensing element of battery charge controller **8** then determines whether battery **10** is fully charged (Step **44**). If battery **10** is not fully charged, battery **8** is charged via charging current from SC **6** (Step **46**). If battery **10** is fully charged, or if SC is not charged at all, then the process ends (Step **48**)**.**

Device interface controller **12** is responsible for managing and prioritizing the energy and power demands of the load of device **2** with regard to the energy and power supplies via current/voltage regulation.

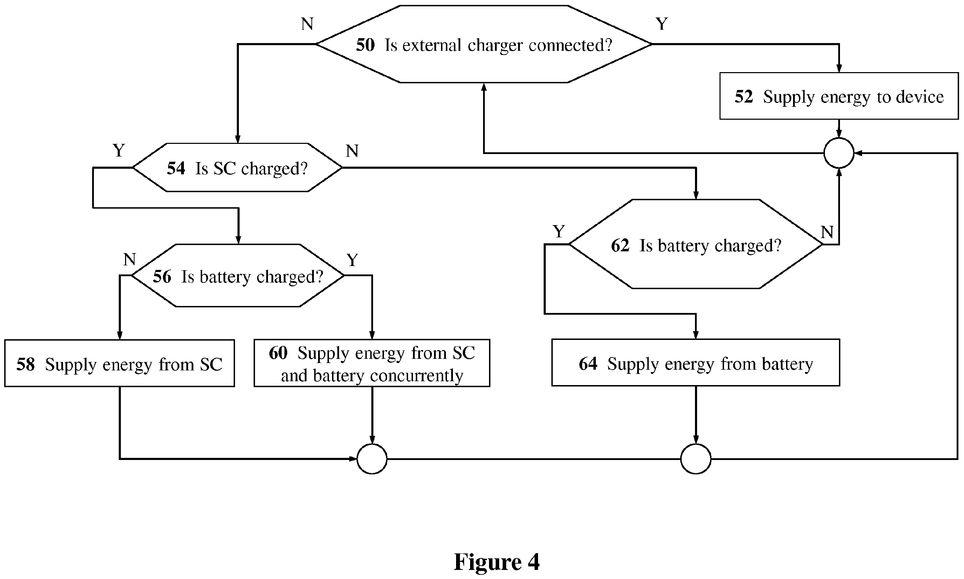

Figure 4 is a simplified flowchart of the major process steps of a device interface controller for adaptive fast-charging for mobile devices and devices having sporadic power-source connection, according to preferred embodiments of the present invention. Device interface controller **12** determines whether an external charger is connected (Step **50**)**.** If an external charger is connected to a power source (IN), then energy and power is supplied from the external charger to device **2** for operation and/or for charging SC **6** and/or battery **10** if they are not fully charged (Step **52**), and the process returns to Step **50.**

If an external charger is not connected to a power source (OUT), then the charge-sensing element of SC charge controller **4** determines whether SC **6** is even partially charged (Step **54**). If SC **6** is even partially charged, then the charge-sensing element of battery charge controller **8** determines whether battery **10** is even partially charged (Step **56**). If battery **10** is not charged at all, then power is supplied solely from SC **6** via charging current to device **2** (Step **58**), and the process returns to Step **50.** If battery **10** is even partially charged in Step **56,** then energy and power is supplied supplied concurrently from both SC **6** and battery **10** to device **2** (Step **60**), and the process returns to Step **50.**

If SC **6** is not charged at all in Step **54,** then the charge-sensing element of battery charge controller **8** determines whether battery **10** is even partially charged (Step **62).** If battery **10** is even partially charged, then energy and power is supplied solely from battery **10** (Step **64**), and the process returns to Step **50.** If battery **10** is not charged at all, then the process returns to Step **50.**

### Simulations

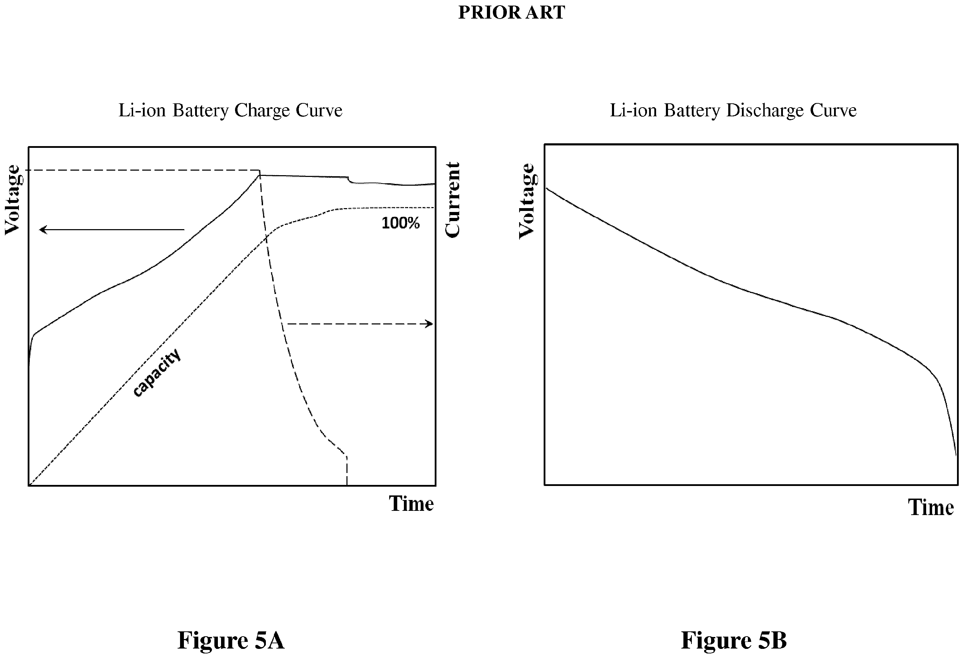

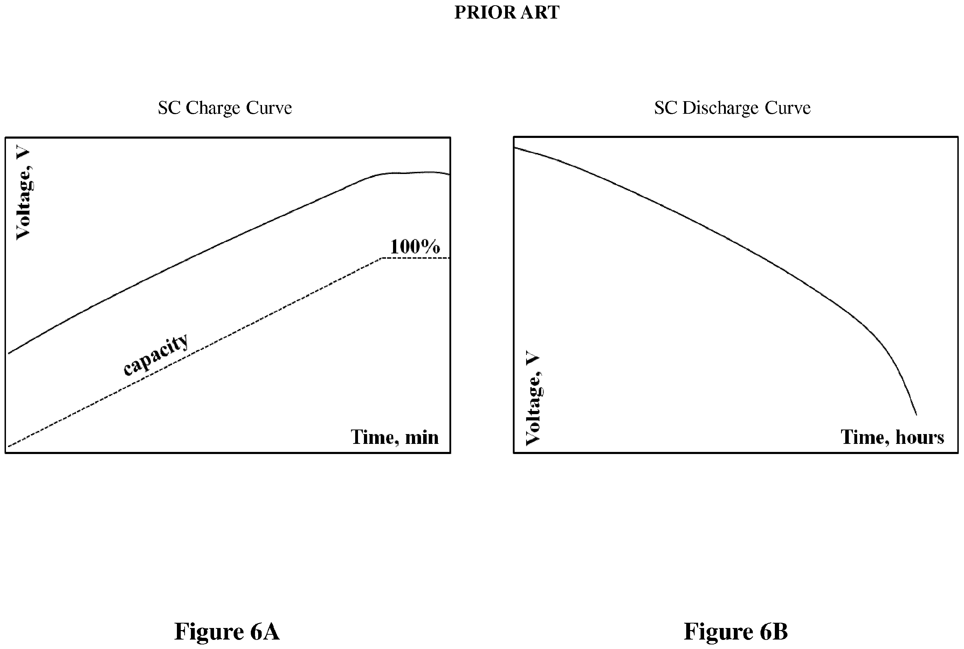

As a reference, Figure 5A is a graph of a typical Li-ion battery charge curve, and Figure 5B is a graph of a typical Li-ion battery discharge curve, as known in the prior art. Figure 6A is a graph of a typical SC charge curve, and Figure 6B is a graph of a typical SC discharge curve, as known in the prior art.

Unlike batteries, SCs may be charged and discharged at very high current, resulting in fast charge/discharge rates. SCs may be charged by constant current. A DC-to-DC constant current regulator is the simplest form of active charging. Either a buck or boost regulator may be used depending on the application. A buck regulator is the preferred topology due to the continuous output charge current.

The present invention relates to systems and methods for adaptive fast-charging for mobile devices and devices having sporadic power-source connection. Charge/discharge simulations were conducted with a FlashBattery system as follows.
➢ SC charging controller - output voltage: up to 10V; output current: up to 30A (e.g., LinearTechnology, LT3741)
➢ SC - capacitance C=180F; voltage V=10.8V; energy E=3Wh; charge time: @30A, ∼60 sec.
➢ Battery charging controller - input voltage: min 200mV; output voltage: up to 4.5V; output current: up to 1000mA; Li-ion rechargeable battery; capacity 1500mAh; voltage V=3.7V; charge time: @500mA, ∼200 min. or @1000mA, ∼100 min. (LinearTechnology, LTC3105)
➢ Device interface controller - current switch between SC and battery.
➢ Device - constant load: 200mA (i.e., average current for 3G mobile service for cell-phone with 2100mAh battery and charge for 11 hrs.)

Using FlashBattery parameters listed above, the following simulation data was obtained: (1) SC fully charged within 60 sec.; (2) SC discharged down to 0.5% capacity; and (3) battery fully charged within 100 or 200 minutes using 1000mA and 500mA, respectively. Details of the simulation parameters are provided below in the following Tables.

**Table 1. Charge/discharge simulation parameters of FlashBattery system for 60-sec. charge, with battery charged in rapid mode using 1000mA (Simulation #1).**

| Time | SC Charging Controller | Battery Charging Controller | Device Interface Controller | SC/Battery |
|---|---|---|---|---|
| t=0 | External charger: IN | Battery charging: OFF | Load current from external charger | SC=0%, Batt=0% |
| t=60sec | External charger: OUT | Battery charging: ON - 1000mA | Load current from SC: 200mA | SC=100%, Batt=0% |
| t∼36min | External charger: OUT | Battery charging: OFF | Load current from battery: 200mA | SC∼0% Batt∼40% |
| t>36min | External charger: OUT | Battery charging: OFF | Load current from battery: 200mA | Batt<40% |

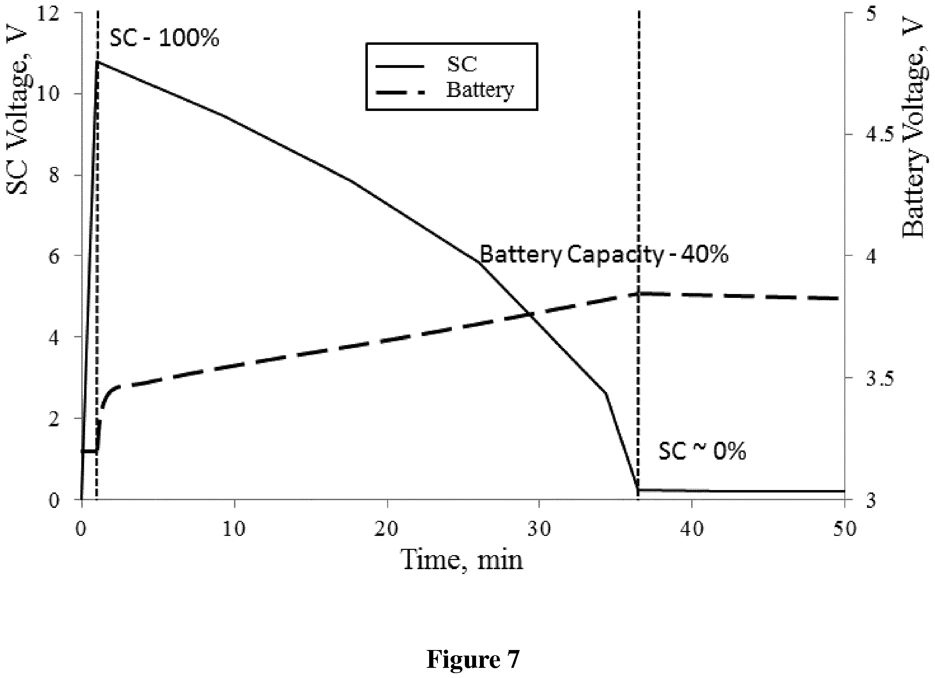

Figure 7 is a graph of a FlashBattery charge/discharge simulation in accordance with the simulation parameters of Table 1, according to preferred embodiments of the present invention.

**Table 2. Charge/discharge simulation parameters of FlashBattery system, 100% charged for both SC and battery, with battery charged in rapid mode using 1000mA (Simulation #2).**

| Time | SC Charging Controller | Battery Charging Controller | Device Interface Controller | SC/Battery |
|---|---|---|---|---|
| t=0 | External charger: IN | Battery charging: OFF | Load current from external charger | SC=0%, Bat=0% |
| t=60sec | External charger: OUT | Battery charging: ON - 1000mA | Load current from SC - 200mA | SC=100%, Bat=0% |
| t∼36min | External charger: OUT | Battery charging: OFF | Load current from battery - 200mA | SC∼0% Batt∼40% |
| t∼60min | External charger: IN | Battery charging: OFF | Load current from external charger | SC∼0% Batt∼35% |
| t∼61min | External Charger "OUT" | Battery charging: ON - 1000mA | Load current from SC - 200mA | SC=100% Batt∼35% |
| t∼97min | External charger: OUT | Battery charging: OFF | Load current from Battery - 200mA | SC∼0% Batt~75% |
| t∼120min | External charger: IN | Battery charging: OFF | Load current from external charger | SC~0% Batt~70% |
| t∼121min | External charger: OUT | Battery charging: ON - 1000mA | Load current from SC - 200mA | SC=100% Batt~70% |
| t∼125min | External charger "OUT" | Battery Charging: ON - constant voltage mode (<1000mA) | Load current from SC - 200mA | SC~80% Batt~80% |
| t∼152min | External charger: OUT | Battery Charging: OFF | Load current from SC - 200mA | SC~60% Batt=100% |
| t∼153min | External charger: IN | Battery Charging: OFF | Load current from external charger | SC~60% Batt=100% |
| t∼153min | External charger: OUT | Battery charging: OFF | Load current from SC - 200mA | SC=100% Batt=100% |
| t>153min | External charger: OUT | Battery charging: OFF | Load current from SC - 200mA | SC<100% Batt=100% |

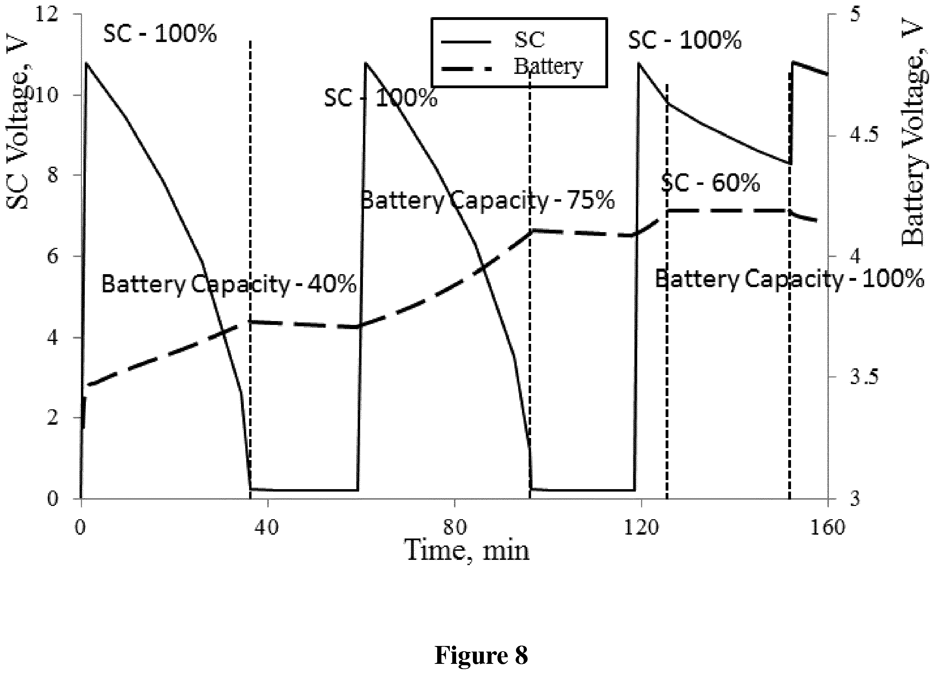

Figure 8 is a graph of a FlashBattery charge/discharge simulation in accordance with the simulation parameters of Table 2, according to preferred embodiments of the present invention.

**Table 3. Charge/discharge simulation parameters of FlashBattery system for 60-sec. charge, operation on battery, with battery charged in rapid mode using 1000mA (Simulation #3).**

| Time | SC Charging Controller | Battery Charging Controller | Device Interface Controller | SC/Battery |
|---|---|---|---|---|
| t=0 | External charger: IN | Battery charging: OFF | Load current from external charger | SC=0%, Batt=0% |
| t=60sec | External charger: OUT | Battery charging: ON - 300mA | Load current from SC - 200mA | SC=100%, Batt=0% |
| t∼36min | External charger: OUT | Battery charging: OFF | Load current from battery - 200mA | SC∼0% Batt∼40% |
| t∼216min | External charger: IN | Battery charging: OFF | Load current from external charger | SC∼0% Batt=0% |
| t∼217min | External charger: OUT | Battery charging: ON - 300mA | Load Current from SC - 200mA | SC=100%, Batt=0% |
| t∼253min | External charger: OUT | Battery charging: OFF | Load current from battery - 200mA | SC∼0% Batt∼40% |
| t>253min | External charger: OUT | Battery charging: OFF | Load current from battery - 200mA | SC∼0% Batt<40% |

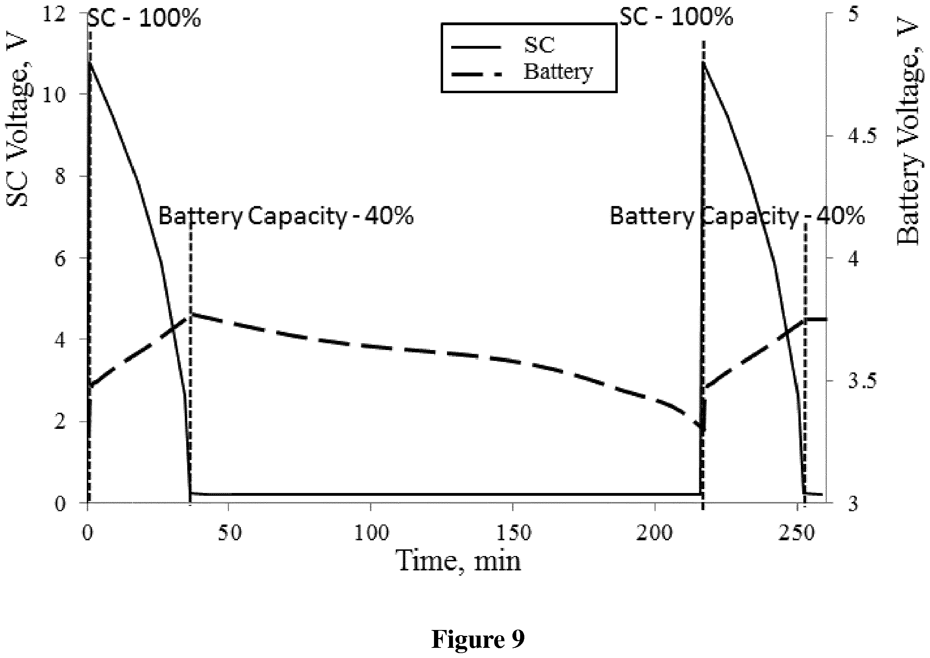

Figure 9 is a graph of a FlashBattery charge/discharge simulation in accordance with the simulation parameters of Table 3, according to preferred embodiments of the present invention.

**Table 4. Charge/discharge simulation parameters of FlashBattery system for low-current battery charge from SC, with battery charged in low-current mode using 500mA (Simulation #4).**

| Time | SC Charging Controller | Battery Charging Controller | Device Interface Controller | SC/Battery |
|---|---|---|---|---|
| t=0 | External charger: IN | Battery charging: OFF | Load current from external charger | SC=0%, Batt=0% |
| t=60sec | External charger: OUT | Battery charging: ON - 500mA | Load current from SC - 200mA | SC=100%, Batt=0% |
| t∼60min | External charger: OUT | Battery charging: OFF | Load current from battery - 200mA | SC∼0% Batt∼35% |
| t>60min | External charger: OUT | Battery charging: OFF | Load current from battery - 200mA | SC∼0% Batt<35% |

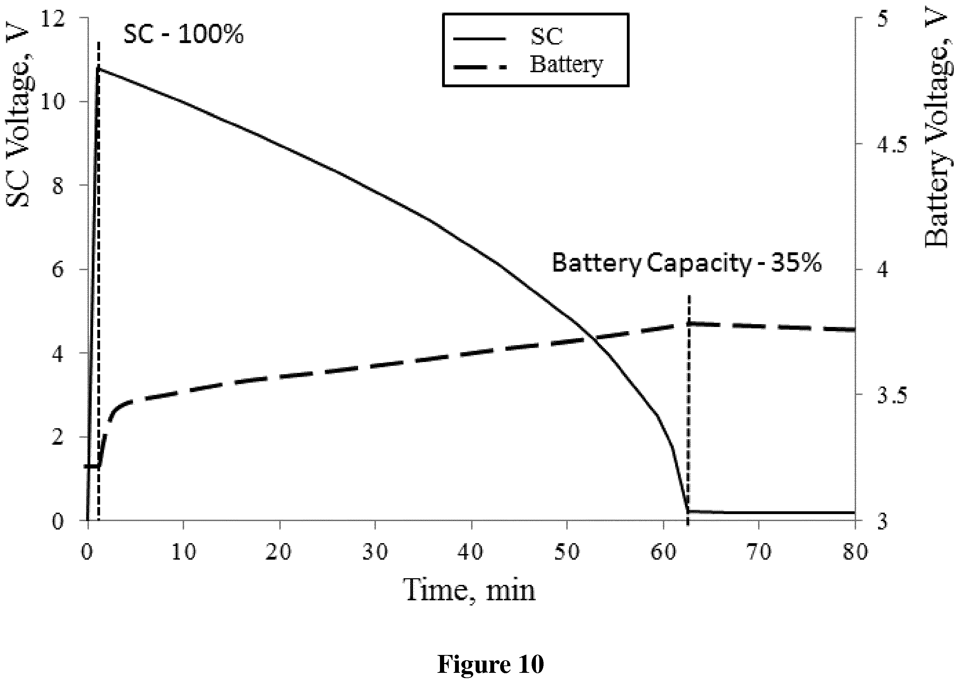

Figure 10 is a graph of a FlashBattery charge/discharge simulation in accordance with the simulation parameters of Table 4, according to preferred embodiments of the present invention. The low-current mode may be applied during standby time when a device is idle in order to save battery lifetime.

**Table 5. Charge/discharge simulation parameters of FlashBattery system, 100% charged from external charger, with battery charged in rapid mode using 1000mA (Simulation #5).**

| Time | SC Charging Controller | Battery Charging Controller | Device Interface Controller | SC/Battery |
|---|---|---|---|---|
| t=0 | External charger: IN | Battery charging: OFF | Load current from charger - 200mA | SC=0%, Batt=0% |
| t=60sec | External charger: IN | Battery charger: ON - 1000mA | Load current from charger - 200mA | SC=100%, Batt=0% |
| t=101min | External charger: OUT | Battery charging: OFF | Load current from SC - 200mA | SC=100%, Batt=100% |
| t>101min | External charger: OUT | Battery charging: OFF | Load current from SC - 200mA | SC<100%, Batt=100% |

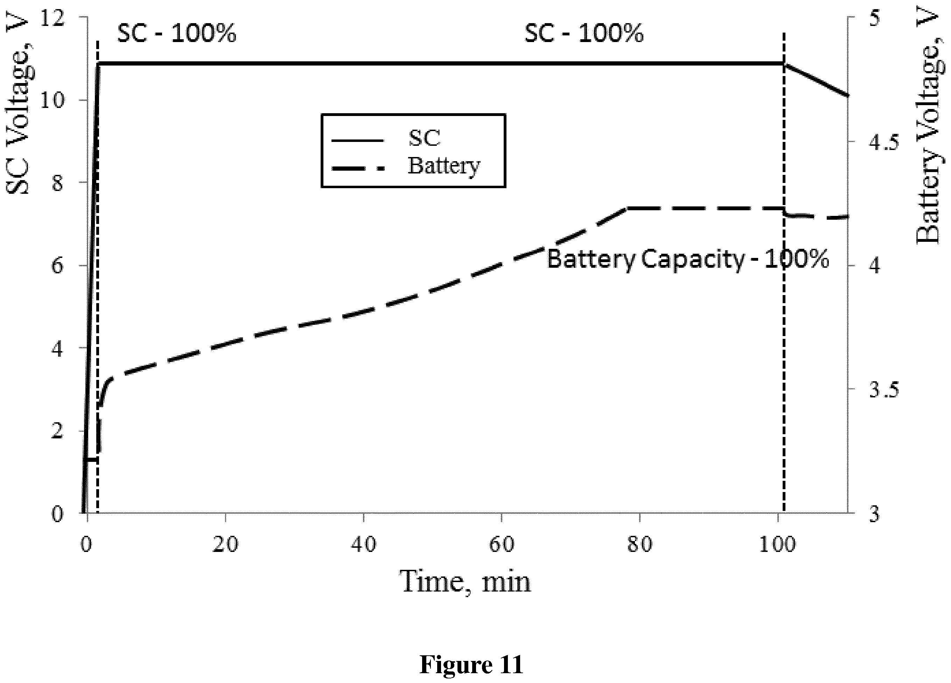

Figure 11 is a graph of a FlashBattery charge/discharge simulation in accordance with the simulation parameters of Table 5, according to preferred embodiments of the present invention.

### Simulation Summary

Table 6 compares the results from the FlashBattery system with a standard cell-phone battery.

**Table 6. Charge/discharge simulation parameters of FlashBattery system with combination SC and battery configuration.**

| Performance Parameters | Standard Cell-phone battery (2500mAh) | SC (3Wh) & Battery (1500mAh) |
|---|---|---|
| Charging time | 2.5-4 hrs. | 60 sec. |
| Operation time (200mA constant load) | ∼11 hrs. | ∼3.5 hrs. |
| Recharge interval | <11 hrs. | ∼35 min. (after SC discharge) |
| Operation time after recharge (200mA constant load) | <11 hrs. | 3.5-11 hrs. |

In such a case, the FlashBattery system provides device power from an SC and battery with flexible and convenient adaptive fast-charging capabilities, resulting in long operation time. Moreover, smart battery charging is enabled by controlling the current, allowing adaptation of the system to user requirements.

## Claims

1. A method of adaptive fast-charging of a mobile device or other device (2) having sporadic power-source connection, the device (2) comprising one or more supercapacitors (6) and one or more rechargeable batteries (10) and being configured for charging at least the one or more supercapacitors (6) from an external charger, the method comprising, when the device is not connected to an external charger:
determining whether a supercapacitor (6) of said device (2) is at least partially charged;
upon detecting said supercapacitor (6) is at least partially charged, determining whether a battery (10) of said device (2) is fully charged; and
upon detecting said battery (10) is not fully charged, charging said battery (10) by discharging said supercapacitor (6).

2. The method of claim 1, wherein said step of charging is adaptively regulated to perform at least one task selected from the group consisting of: preserving a lifetime of said battery (10) by controlling a current to said battery, and discharging said supercapacitor (6) in order to charge said battery.

3. The method of claim 2, wherein said discharging enables said supercapacitor (6) to be subsequently recharged.

4. The method according to any of the preceding claims, further comprising the steps of:
prior to said determining whether a supercapacitor (6) of said device (2) is at least partially charged, determining whether an external charger is connected to said device (2); and
upon detecting said external charger is connected to said device (2), charging said supercapacitor (6) and/or said battery (10) from said external charger.

5. The method of claim 4, further comprising the step of:
upon detecting said external charger is not connected to said device (2), supplying energy to said device (2) from said supercapacitor (6) and/or said battery (10).

6. An electrical or electronic device (2) comprising:
one or more supercapacitors (6) and one or more rechargeable batteries (10), the device being configured for charging at least the one or more supercapacitors (6) from an external charger; a supercapacitor charging controller (4) configured for determining whether a supercapacitor of said device (2) is at least partially charged; and a battery charging controller (8) configured for determining whether a battery (10) of said device (2) is charged;
wherein said battery charging controller (8) is configured for, when the device is not connected to an external charger (40), upon detecting that a supercapacitor of said device is at least partially charged (24) and a battery (10) of said device is not fully charged (44), charging said battery (10) from said supercapacitor (6) by discharging said supercapacitor (46).

7. The device of claim 6, wherein said charging is adaptively regulated to perform at least one task from the group consisting of: preserving a lifetime of said battery (10) by controlling a current to said battery, and discharging said supercapacitor (6) in order to charge said battery (10).

8. The device of claim 7 said discharging enables said supercapacitor (6) to be subsequently recharged.

9. The device of any of claims 6 to 8, wherein said supercapacitor charging controller (4) is further configured for:
prior to said determining (24) whether a supercapacitor (6) of a device (2) is at least partially charged, determining (20) whether an external charger is connected to said device (2); and
upon detecting (20) said external charger is connected to said device (2), charging (32, 34) said supercapacitor (6) and/or said battery (10) from said external charger.

10. The system of claim 9, wherein said supercapacitor charging controller (4) is further configured for:
upon detecting said external charger is not connected to said device, supplying energy to said device from said supercapacitor and/or said battery.

11. A non-transitory computer-readable medium, having embodied thereon computer-readable code, the computer-readable code having program code for implementation in and adaptive fast-charging of a mobile device or other device (2) having sporadic power-source connection, the device (2) comprising one or more supercapacitors (6) and one or more rechargeable batteries and being configured for charging at least the one or more supercapacitors (6) from an external charger, wherein the program code when implemented causes the device (2), when the device is not connected to an external charger, to perform the steps of:
determining whether a supercapacitor (6) of said device (2) is at least partially charged;
upon detecting said supercapacitor is at least partially charged, determining whether a battery (10) of said device (2) is fully charged; and
upon detecting said battery is not fully charged, charging said battery (10) from said supercapacitor (6).

12. The computer-readable medium of claim 11, wherein said firstly charging is adaptively regulated to perform at least one task from the group consisting of: preserving a lifetime of said battery by controlling a current to said battery (10), and discharging said supercapacitor (6) in order to charge said battery (10).

13. The computer-readable medium of claim 11 or 12 wherein said discharging enables said supercapacitor (6) to be subsequently recharged.

14. The computer-readable medium of any of claims 11 to 13, wherein the program code when implemented further causes the device (2) to perform the steps of:
prior to said determining whether a supercapacitor (6) of said device (2) is at least partially charged, determining whether an external charger is connected to said device (2); and
upon detecting said battery (10) is not charged, firstly charging said from said supercapacitor (6).

15. The computer-readable medium of claim 14, wherein the program code when implemented further causes the device (2) to perform the steps of:
upon detecting said external charger is not connected to said device, supplying energy to said device from said supercapacitor (6) and/or said battery (10).

## Patentansprüche

1. Ein Verfahren zur adaptiven Schnellladung eines mobilen Gerätes oder eines anderen Gerätes (2) mit sporadischer Verbindung zu einer Energiequelle, das Gerät (2) weist dabei einen oder mehrere Superkondensatoren (6) und eine oder mehrere wiederaufladbare Batterien (10) auf und ist so gestaltet, dass es mindestens den einen oder die mehreren Superkondensatoren (6) über ein externes Ladegerät laden kann, das Verfahren weist dabei Folgendes auf, wenn das Gerät nicht mit einem externen Ladegerät verbunden ist:
die Bestimmung, ob ein Superkondensator (6) des besagten Gerätes (2) zumindest teilweise geladen ist;
bei der Erkennung, dass der Superkondensator (6) zumindest teilweise geladen ist, die Bestimmung, ob eine Batterie (10) des besagten Gerätes (2) vollständig geladen ist; und
bei der Erkennung, dass besagte Batterie (10) nicht vollständig geladen ist, das Laden der besagten Batterie (10) durch Entladen des besagten Superkondensators (6).

2. Das Verfahren gemäß Anspruch 1, wobei dieser Schritt des Ladens adaptiv geregelt wird, um zumindest eine Aufgabe auszuführen, ausgewählt aus der Gruppe bestehend aus:
Schonung einer Lebensdauer dieser Batterie (10) durch die Regelung eines Stroms zu dieser Batterie, und die Entladung des besagten Superkondensators (6), um die Batterie zu laden.

3. Das Verfahren gemäß Anspruch 2, wobei diese Entladung dazu führt, dass der Superkondensator (6) nachfolgend wieder aufgeladen werden kann.

4. Das Verfahren gemäß eines der vorhergehenden Ansprüche, das darüberhinaus die folgenden Schritte aufweist: vor der Bestimmung, ob ein Superkondensator (6) des besagten Gerätes (2) zumindest teilweise geladen ist, die Bestimmung, ob ein externes Ladegerät mit diesem Gerät (2) verbunden ist; und
bei der Erkennung, dass ein externes Ladegerät an dieses Gerät (2) angeschlossen ist, das Laden dieses Superkondensators (6) und/oder der Batterie (10) über dieses externe Ladegerät.

5. Das Verfahren gemäß Anspruch 4, das darüberhinaus den folgenden Schritt aufweist:
bei der Erkennung, dass ein externes Ladegerät nicht an dieses Gerät (2) angeschlossen ist, die Zufuhr von Energie zu diesem Gerät (2) von diesem Superkondensator (6) und/oder der Batterie (10).

6. Ein elektrisches oder elektronisches Gerät (2), das Folgendes aufweist:
einen oder mehrere Superkondensatoren (6) und eine oder mehrere wiederaufladbare Batterien (10), das Gerät ist dabei so gestaltet, dass es zumindest einen oder mehrere Superkondensatoren (6) über ein externes Ladegerät laden kann; einen Superkondensator-Laderegler (4), der so gestaltet ist, dass er bestimmen kann, ob ein Superkondensator des besagten Gerätes (2) zumindest teilweise geladen ist; und ein Batterie-Laderegler (8), der so gestaltet ist, dass er bestimmen kann, ob eine Batterie (10) des besagten Gerätes (2) geladen ist;
wobei der Batterie-Laderegler (8) so gestaltet ist, dass er, wenn das Gerät nicht an das externe Ladegerät (40) angeschlossen ist, bei Erkennung, dass ein Superkondensator des Gerätes zumindest teilweise geladen ist (24) und eine Batterie (10) des Gerätes nicht vollständig geladen ist (44), diese Batterie (10) über den Superkondensator (6) lädt, indem sich der Superkondensator (46) entlädt.

7. Das Gerät gemäß Anspruch 6, wobei dieser Schritt des Ladens adaptiv geregelt wird, um zumindest eine Aufgabe auszuführen, ausgewählt aus der Gruppe bestehend aus:
Schonung einer Lebensdauer dieser Batterie (10) durch die Regelung eines Stroms zu dieser Batterie, und die Entladung des besagten Superkondensators (6), um diese Batterie (10) zu laden.

8. Das Gerät gemäß Anspruch 7, wobei diese Entladung dazu führt, dass der Superkondensator (6) nachfolgend wieder aufgeladen werden muss.

9. Das Gerät gemäß eines der Ansprüche 6 bis 8, wobei der Superkondensator-Laderegler (4) darüberhinaus für Folgendes gestaltet ist:
vor der Bestimmung (24), ob ein Superkondensator (6) des besagten Gerätes (2) zumindest teilweise geladen ist, die Bestimmung (20), ob ein externes Ladegerät mit diesem Gerät (2) verbunden ist; und
bei der Erkennung (20), dass ein externes Ladegerät an dieses Gerät (2) angeschlossen ist, das Laden (32, 34) dieses Superkondensators (6) und/oder der Batterie (10) über dieses externe Ladegerät.

10. Das System gemäß Anspruch 9, wobei der Superkondensator-Laderegler (4) darüberhinaus für Folgendes gestaltet ist:
bei der Erkennung, dass ein externes Ladegerät nicht an dieses Gerät angeschlossen ist, die Zufuhr von Energie zu diesem Gerät von diesem Superkondensator und/oder der Batterie.

11. Ein nichtflüchtiges, computerlesbares Speichermedium mit einem darin enthaltenen computerlesbaren Code, der computerlesbare Code verfügt dabei über einen Programm-Code für die Implementierung in und für die Schnellladung eines mobilen Gerätes oder eines anderen Gerätes (2) mit sporadischer Verbindung zu einer Energiequelle, das Gerät (2) weist dabei einen oder mehrere Superkondensatoren (6) und eine oder mehrere wiederaufladbare Batterien auf und ist so gestaltet, dass es mindestens den einen oder die mehreren Superkondensatoren (6) über ein externes Ladegerät laden kann, wobei der Programm-Code, wenn er implementiert ist, dafür sorgt, dass das Gerät (2), wenn das Gerät nicht mit einem externen Ladegerät verbunden ist, die folgenden Schritte ausführt:
die Bestimmung, ob ein Superkondensator (6) des besagten Gerätes (2) zumindest teilweise geladen ist;
bei der Erkennung, dass der Superkondensator zumindest teilweise geladen ist, die Bestimmung, ob eine Batterie (10)
des besagten Gerätes (2) vollständig geladen ist; und
bei der Erkennung, dass besagte Batterie nicht vollständig geladen ist, das Laden der besagten Batterie (10) über den Superkondensator (6).

12. Das computerlesbare Medium gemäß Anspruch 11, wobei das erstere Laden adaptiv geregelt wird, um zumindest eine Aufgabe auszuführen, aus der Gruppe bestehend aus:
Schonung einer Lebensdauer dieser Batterie durch die Regelung eines Stroms zu dieser Batterie (10), und die Entladung des besagten Superkondensators (6), um diese Batterie (10) zu laden.

13. Das computerlesbare Medium gemäß Anspruch 11 oder 12, wobei diese Entladung dazu führt, dass der Superkondensator (6) nachfolgend wieder aufgeladen werden kann.

14. Das computerlesbare Medium gemäß eines der Ansprüche 11 bis 13, wobei der Programm-Code, wenn er implementiert ist, darüberhinaus dafür sorgt, dass das Gerät (2) die folgenden Schritte ausführt:
Vor der Bestimmung, ob ein Superkondensator (6) des besagten Gerätes (2) zumindest teilweise geladen ist, die Bestimmung, ob ein externes Ladegerät mit diesem Gerät (2) verbunden ist; und bei der Erkennung, dass besagte Batterie (10) nicht vollständig geladen ist, zunächst das Laden über den Superkondensator (6).

15. Das computerlesbare Medium gemäß Anspruch 14, wobei der Programm-Code, wenn er implementiert ist, darüberhinaus dafür sorgt, dass das Gerät (2) die folgenden Schritte ausführt:
bei der Erkennung, dass ein externes Ladegerät nicht an dieses Gerät angeschlossen ist, die Zufuhr von Energie zu diesem Gerät von diesem Superkondensator (6) und/oder der Batterie (10).

## Revendications

1. Un procédé de recharge rapide adaptative d'un dispositif mobile ou un autre dispositif (2) présentant une connexion de source de puissance sporadique, le dispositif (2) comprenant un ou plusieurs supercondensateurs (6) et une ou plusieurs batteries rechargeables (10) et étant configuré pour charger au moins le ou les supercondensateurs (6) à partir d'un chargeur externe, le procédé comprenant, lorsque le dispositif n'est pas connecté à un chargeur externe :
la détermination si un supercondensateur (6) dudit dispositif (2) est au moins partiellement chargé ;
lors de la détection que ledit supercondensateur (6) est au moins partiellement chargé, la détermination si une batterie (10) dudit dispositif (2) est complètement chargée ; et
lors de la détection que ladite batterie (10) n'est pas complètement chargée, la charge de ladite batterie (10) par la décharge dudit supercondensateur (6).

2. Le procédé selon la revendication 1, dans lequel ladite étape de charge est régulée de manière adaptative pour effectuer au moins une tâche sélectionnée parmi le groupe comprenant : la préservation de la durée de vie de ladite batterie (10) par la maîtrise d'un courant à ladite batterie et la décharge dudit supercondensateur (6) afin de charger ladite batterie.

3. Le procédé selon la revendication 2, dans lequel ladite décharge permet audit supercondensateur (6) d'être rechargé ultérieurement.

4. Le procédé selon l'une quelconque des revendications précédentes, comprenant en outre les étapes suivantes : avant ladite détermination si un supercondensateur (6) dudit dispositif (2) est au moins partiellement chargé, la détermination si un chargeur externe est connecté audit dispositif (2) ; et
lors de la détection que ledit chargeur externe est connecté au dispositif (2), la charge dudit supercondensateur (6) et/ou de ladite batterie (10) à partir dudit chargeur externe.

5. Le procédé selon la revendication 4 comprenant en outre les étapes suivantes :
lors de la détection que ledit chargeur externe n'est pas connecté audit dispositif (2), la fourniture d'énergie audit dispositif (2) à partir dudit supercondensateur (6) et/ou de ladite batterie (10).

6. Un dispositif électrique ou électronique (2) comprenant :
un ou plusieurs supercondensateurs (6) et une ou plusieurs batteries rechargeables (10), le dispositif étant configuré pour charger au moins le ou les supercondensateurs (6) à partir d'un chargeur externe ; un dispositif de commande de la charge du supercondensateur (4) configuré pour déterminer si un supercondensateur dudit dispositif (2) est au moins partiellement chargé ; et un dispositif de commande de la charge de la batterie (8) configuré pour déterminer si une batterie (10) dudit dispositif (2) est chargée ;
dans lequel ledit dispositif de commande de la charge de ladite batterie (8) est configuré pour, lorsque le dispositif n'est pas connecté à un chargeur externe (40), lors de la détection qu'un supercondensateur dudit dispositif est au moins partiellement chargé (24) et une batterie (10) dudit dispositif n'est pas complètement chargée (44), la charge de ladite batterie (10) à partir dudit supercondensateur (6) par la décharge dudit supercondensateur (46).

7. Le dispositif selon la revendication 6, dans lequel l'étape de charge est régulée de manière adaptative pour effectuer au moins une tâche parmi le groupe comprenant : la préservation de la durée de vie de ladite batterie (10) par la maîtrise d'un courant à ladite batterie et la décharge dudit supercondensateur (6) afin de charger ladite batterie (10).

8. Le dispositif selon la revendication 7, dans lequel ladite décharge permet audit supercondensateur (6) d'être rechargé ultérieurement.

9. Le dispositif de l'une quelconque des revendications 6 à 8, dans lequel le dispositif de commande de la charge dudit supercondensateur (4) est configuré en outre pour :
avant ladite détermination (24) si un supercondensateur (6) d'un dispositif (2) est au moins partiellement chargé, la détermination (20) si un chargeur externe est connecté audit dispositif (2) ; et
lors de la détection (20) que ledit chargeur externe est connecté audit dispositif (2), la charge (32, 34) dudit supercondensateur (6) et/ou de ladite batterie (10) à partir dudit chargeur externe.

10. Le système selon la revendication 9, dans lequel le dispositif de commande de la charge dudit supercondensateur (4) est configuré en outre pour :
lors de la détection que ledit chargeur externe n'est pas connecté audit dispositif, la fourniture d'énergie audit dispositif à partir dudit supercondensateur et/ou de ladite batterie.

11. Un support lisible par ordinateur non transitoire présentant un code lisible par ordinateur sur celui-ci, le code lisible par ordinateur présentant un code de programme destiné à l'implémentation et la recharge rapide adaptative d'un dispositif mobile ou autre dispositif (2) présentant une connexion de source de puissance sporadique, le dispositif (2) comprenant un ou plusieurs supercondensateurs (6) et une ou plusieurs batteries rechargeables et étant configuré pour charger au moins le ou les supercondensateurs (6) à partir d'un chargeur externe, dans lequel le code de programme lorsqu'il est implémenté amène le dispositif (2), lorsque le dispositif n'est pas connecté à un chargeur externe, à effectuer les étapes suivantes :
la détermination si un supercondensateur (6) dudit dispositif (2) est au moins partiellement chargé ;
lors de la détection que ledit supercondensateur est au moins partiellement chargé, la détermination si une batterie (10) dudit dispositif (2) est complètement chargée ; et
lors de la détection que ladite batterie n'est pas complètement chargée, la charge de ladite batterie (10) par la décharge dudit supercondensateur (6).

12. Le support lisible par ordinateur selon la revendication 11, dans lequel ladite charge en premier lieu est régulée de manière adaptative pour effectuer au moins une tâche parmi le groupe comprenant : la préservation de la durée de vie de ladite batterie par la maîtrise d'un courant à ladite batterie (10) et la décharge dudit supercondensateur (6) afin de charger ladite batterie (10).

13. Le support lisible par ordinateur selon la revendication 11 ou 12, dans lequel ladite décharge permet audit supercondensateur (6) d'être rechargé ultérieurement.

14. Le support lisible par ordinateur de l'une quelconque des revendications 11 à 13, dans lequel le code de programme lorsqu'il est en outre implémenté amène le dispositif (2) à effectuer les étapes suivantes :
avant ladite détermination si un supercondensateur (6) dudit dispositif (2) est au moins partiellement chargé, la détermination si un chargeur externe est connecté audit dispositif (2) ; et
lors de la détection que ladite batterie (10) n'est pas chargée, la charge en premier lieu dudit supercondensateur (6).

15. Le support lisible par ordinateur selon la revendication 14, dans lequel le code de programme lorsqu'il est en outre implémenté amène le dispositif (2) à effectuer les étapes suivantes :
lors de la détection que ledit chargeur externe n'est pas connecté audit dispositif, la fourniture d'énergie audit dispositif à partir dudit supercondensateur (6) et/ou de ladite batterie (10).
